# EUROPEAN PATENT APPLICATION

(11) **EP 2 750 122 A1**
(43) Date of publication of application: **02.07.2014**
(21) Application number: 12790777.2
(22) Date of filing: 21.08.2012
(51) Int. Cl.: G09G 3/20, G09G 3/36

(54) **GATE INTEGRATED DRIVE CIRCUIT, SHIFT REGISTER AND DISPLAY SCREEN**

(30) Priority: 22.08.2011 CN 201110241400
(71) Applicant: Beijing Boe Optoelectronics Technology Co. Ltd., Beijing 100176 (CN)
(72) Inventor: CHEN, Xi, Beijing 100176 (CN)
(74) Representative: Brötz, Helmut
(86) International application number: PCT/CN2012/080420
(87) International publication number: WO 2013/026387

(57) **Abstract**

The embodiment of the present disclosure relates to a technical field of liquid crystal display, and particularly, to a gate driver on array, a shifting register and a display screen. The gate driver on array comprises: a first TFT, a second TFT, a third TFT, a fourth TFT, a capacitor and a pulling-down module, the pulling-down module is connected among a first clock signal input terminal, a second clock signal input terminal, a first node and an output terminal, and is connected with a low voltage signal terminal, for maintaining the first node and the output terminal being in a low level during a non-operation period of the gate driver on array. Thus, the gate driver on array may achieve a bidirectional scan by designing the functions of the input terminal and the reset terminal in the gate driver on array as being implemented symmetrically, without changing a charging-discharging characteristic of nodes, which ensures a reliability and stabilization of the circuit.

## Description

### FIELD OF THE DISCLOSURE

The present disclosure relates to a technical field of liquid crystal display, and particularly, to a gate driver on array, a shifting register and a display screen.

### BACKGROUND

The Gate Drive on Array (GOA) refers to integrate a gate driver of a LCD (Liquid Crystal Display) panel on a glass substrate. Then the GOA is connected with gates of an array substrate to control gate signals as a shifting register. As compared with the traditional COF (Chip on Film) and COG (Chip on Glass) processes, the GOA technique saves cost.

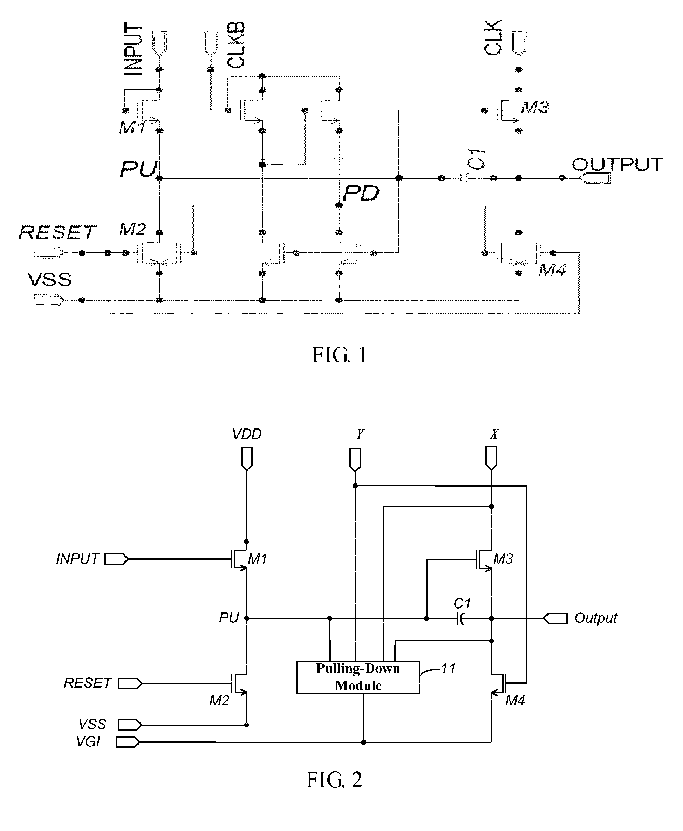

However, a scan direction of the GOA panel in the prior art is only a single direction, for example, the scan is performed from up to down or performed from down to up. As shown in Fig.1, which illustrates a GOA circuit with an unidirectional scan in the prior art, the operation principle of the GOA circuit is as follows: when a signal at an input terminal INPUT is in a high level, a TFT (Thin Film Transistor) M1 is turned on so as to charge a PU node; when a clock signal CLK is in the high level, a M3 is turned on and an output terminal OUTPUT outputs pulse signal of the CLK; at the same time, the PU node is pulled-up by a bootstrapping effect of a capacitor C1; subsequently, a reset terminal RESET is in the high level, so that TFTs M2 and M4 are turned on so as to discharge the PU node and the OUTPUT; next, a PD node is controlled by a clock signal CLKB so as to discharge the PU node and the OUTPUT, thus it is ensured that no noise occurs in the GOA circuit in the non-operation period. When such panel is used along with usage of a system terminal, sometimes it needs to debug software again to reverse an image since ICs of different system terminals have differences (the IC is upward or downward), which brings many inconveniences.

### SUMMARY

A gate driver on array (GOA), a shifting register and a display screen according to embodiments of the present disclosure may achieve a bidirectional scan of the GOA and ensure a stabilization of the gate driver on array.

A gate driver on array according to the embodiments of the present disclosure comprises:

a first thin film field effect transistor TFT, a gate of which is connected with an input terminal of the gate driver on array circuit, a drain of which is connected with a power supply voltage terminal VDD, and a source of which is connected with a first node being a pulling-up node;

a second TFT, a gate of which is connected with a reset terminal of the gate driver on array, a source of which is connected with a common connection voltage terminal VSS, and a drain of which is connected with the first node;

a third TFT, a gate of which is connected with the first node, a drain of which is connected with a first clock signal input terminal, and a source of which is connected with an output terminal;

a fourth TFT, a gate of which is connected with a second clock signal input terminal, a drain of which is connected with the output terminal, and a source of which is connected with a low voltage signal terminal;

a capacitor which is connected between the first node and the output terminal;

a pulling-down module, which is connected among the first clock signal input terminal, the second clock signal input terminal, the first node and the output terminal, and is connected with the low voltage signal terminal, for maintaining the first node and the output terminal being in the low level during a non-operation period of the gate driver on array.

The embodiments of the present disclosure provide a shifting register comprising a plurality of the above-described gate drivers on array, each of the gate driver on array is used to control a gate signal of respective row, wherein an input terminal of the gate driver on array for controlling the gate signal of the N^{th} row is connected with an output terminal of the gate driver on array for controlling the gate signal of the (N-1)^{th}row, an output terminal of the gate driver on array for controlling the gate signal of the N^{th}row is connected with an input terminal of the gate driver on array for controlling the gate signal of the (N+1)^{th} row, and a reset terminal of the gate driver on array for controlling the gate signal of the N^{th} row is connected with the output terminal of the gate driver on array for controlling the gate signal of the (N+1)^{th}row, wherein N is equal to or more than 2.

The embodiments of the present disclosure provide a display screen comprising: the above-described shifting register and an array substrate;

signal output terminals of the shifting register are connected with gate lines of the array substrate, respectively.

The gate driver on array, shifting register and display screen according to the embodiments of the present disclosure enable the gate driver on array to achieve a bidirectional scan by designing the functions of the input terminal and the reset terminal in the gate driver on array as being implemented symmetrically, without changing a charging-discharging characteristic of nodes, which ensures a reliability and stabilization of the circuit.

### BRIEF DESCRIPTION OF THE DRAWINGS

Fig.1 is a schematic diagram of the GOA in the prior art;
Fig.2 is a schematic diagram illustrating a structure of the gate driver on array according to an embodiment of the present disclosure;
Fig.3 is a schematic diagram illustrating a structure of the shifting register according to another embodiment of the present disclosure;
Fig.4 is a schematic diagram illustrating a detailed structure of the gate driver on array according to the embodiments of the present disclosure;
Fig.5 is a timing sequence chart of voltages of respective terminals of the gate drivers on array for controlling the gate signal corresponding to an odd row during a forward scan according to the embodiments of the present disclosure;
Fig. 6 is a timing sequence chart of voltages of respective terminals of the gate drivers on array for controlling the gate signal corresponding to an even row during a forward scan according to the embodiments of the present disclosure;
Fig.7 is a timing sequence chart of voltages of respective terminals of the gate driver on array for controlling the gate signal corresponding to an odd row during a backward scan according to the embodiments of the present disclosure; and
Fig.8 is a timing sequence chart of voltages of respective terminals of the gate drivers on array for controlling the gate signal corresponding to an even row during a backward scan according to the embodiments of the present disclosure.

### DETAILED DESCRIPTION

Below detailed implementations of the disclosure will be described in further details in connection with the accompanying drawings.

The embodiments of the present disclosure provide a gate driver on array, as shown in Fig.2, the gate driver on array comprises:

a first thin film field effect transistor TFT M1, a gate of which is connected with an input terminal INPUT of the gate driver on array, a drain of which is connected with a power supply voltage terminal VDD, and a source of which is connected with a first node PU being a pulling-up node;

a second TFT M2, a gate of which is connected with a reset terminal RESET of the gate driver on array, a source of which is connected with a common connection voltage terminal VSS, and a drain of which is connected with the first node PU;

a third TFT M3, a gate of which is connected with the first node PU, a drain of which is connected with a first clock signal input terminal X, and a source of which is connected with an output terminal OUTPUT;

a fourth TFT M4, a gate of which is connected with a second clock signal input terminal Y, a drain of which is connected with the output terminal OUTPUT, and a source of which is connected with a low voltage signal terminal VGL;

a capacitor C1 which is connected between the first node PU and the output terminal OUTPUT;

a pulling-down module 11, which is connected among the first clock signal input terminal X, the second clock signal input terminal Y, the first node PU and the output terminal OUTPUT, and is connected with the low voltage signal terminal VGL, for maintaining the first node PU and the output terminal OUTPUT being in the low level during a non-operation period of the gate driver on array.

Wherein the pulling-down module 11 comprises:

a fifth TFT, a drain of which is connected with the second clock signal input terminal, and a source of which is connected with a second node being a pulling-down node;

a sixth TFT, a drain of which is connected with the second node, a gate of which is connected with the first node, and a source of which is connected with the low voltage signal terminal;

a seventh TFT, gate and drain of which are connected with the second clock signal input terminal together, and a source of which is connected with a gate of the fifth TFT;

a eighth TFT, a drain of which is connected with the source of the seventh TFT, a gate of which is connected with the first node, and a source of which is connected with the low voltage signal terminal;

a ninth TFT, a drain of which is connected with the first node, a gate of which is connected with the second node, and a source of which is connected with the low voltage signal terminal;

a tenth TFT, a drain of which is connected with the output terminal, a gate of which is connected with the second node, and a source of which is connected with the low voltage signal terminal.

In an example, the first clock signal input terminal X of the gate driver on array is connected to a first clock signal line, such as CLK, and the second clock signal input terminal Y thereof is connected to a second clock signal line, such as CLKB, when the gate driver on array is used to control the gate signal corresponding to an odd row; the second clock signal input terminal Y of the gate driver on array is connected to the first clock signal line, and the first clock signal input terminal X thereof is connected to a second clock signal line, when the gate driver on array is used to control the gate signal corresponding to an even row.

A bidirectional scan can be performed by a cascade of a plurality of the above-described gate driver on array and comprises the following cases.

(1) In a forward scan, that is, the scan is performed from the first row to the last row, and the gate driver on array is used to control the gate signal corresponding to an odd row.

When the forward scan is initiated, the VDD provides a constant high level and the VSS provides a constant low level, a high level pulse signal is input to the input terminal of the gate driver on array, and the first node is charged via the drain of the first TFT; the first clock signal input terminal receives a high level clock signal provided by the first clock signal line, the output terminal is controlled by the third TFT so as to output a high level; the sixth TFT is turned on and pulls down the voltage at the second node to the voltage at the low voltage signal terminal; the reset terminal connected to the gate of the second TFT is in the high level, and the first node is discharged; the second clock signal input terminal receives a high level clock signal provided by the second clock signal line, and the output terminal is discharged via the fourth TFT; the second node is charged through the fifth TFT, the ninth TFT is controlled to discharge the first node and the tenth TFT is controlled to discharge the output terminal.

(2) In the forward scan, that is, the scan is performed from the first row to the last row, and the gate driver on array is used to control the gate signal corresponding to an even row.

When the forward scan is initiated, the VDD provides a constant high level and the VSS provides a constant low level, a high level pulse signal is input to the input terminal of the gate driver on array, and the first node is charged via the drain of the first TFT; the first clock signal input terminal receives a high level clock signal provided by the second clock signal line, the output terminal is controlled by the third TFT so as to output the high level; the sixth TFT is turned on and pulls down the voltage at the second node to the voltage at the low voltage signal terminal; the reset terminal connected to the gate of the second TFT is in the high level, and the first node is discharged; the second clock signal input terminal receives a high level clock signal provided by the first clock signal line, and the output terminal is discharged via the fourth TFT; the second node is charged through the fifth TFT, the ninth TFT is controlled to discharge the first node and the tenth TFT is controlled to discharge the output terminal.

(3) In a backward scan, that is, the scan is performed from the last row to the first row, and the gate driver on array is used to control the gate signal corresponding to an odd row.

When the backward scan is initiated, the VDD provides a constant low level and the VSS provides a constant high level, a high level pulse signal is input to the reset terminal of the gate driver on array, the first node is charged via the source of the second TFT; the first clock signal input terminal receives a high level clock signal provided by the first clock signal line, the output terminal is controlled by the third TFT so as to output a high level; the sixth TFT is turned on and pulls down the voltage at the second node to the voltage at the low voltage signal terminal; the input terminal connected to the gate of the first TFT is in the high level, and the first node is discharged; the second clock signal input terminal receives a high level clock signal provided by the second clock signal line, and the output terminal is discharged via the fourth TFT; the second node is charged through the fifth TFT, the ninth TFT is controlled to discharge the first node and the tenth TFT is controlled to discharge the output terminal.

(4) In the backward scan, that is, the scan is performed from the last row to the first row, and the gate driver on array is used to control the gate signal corresponding to an even row.

When the backward scan is initiated, the VDD provides a constant low level and the VSS provides a constant high level, a high level pulse signal is input to the reset terminal of the gate driver on array, the first node is charged via the source of the second TFT; the first clock signal input terminal receives a high level clock signal provided by the second clock signal line, the output terminal is controlled by the third TFT so as to output a high level; the sixth TFT is turned on and pulls down the voltage at the second node to the voltage at the low voltage signal terminal; the input terminal connected to the gate of the first TFT is in the high level, and the first node is discharged; the second clock signal input terminal receives a high level clock signal provided by the first clock signal line, and the output terminal is discharged via the fourth TFT; the second node is charged through the fifth TFT, the ninth TFT is controlled to discharge the first node and the tenth TFT is controlled to discharge the output terminal.

In an example, the low voltage signal terminal is used for providing the constant low level to the gate driver on array.

It can be seen from the above description that the gate driver on array according to the embodiments of the present disclosure enable the gate driver on array to achieve a bidirectional scan by designing the functions of the input terminal and the reset terminal in the gate driver on array as being implemented symmetrically, without changing a charging-discharging characteristic of nodes, which ensures a reliability and stabilization of the circuit.

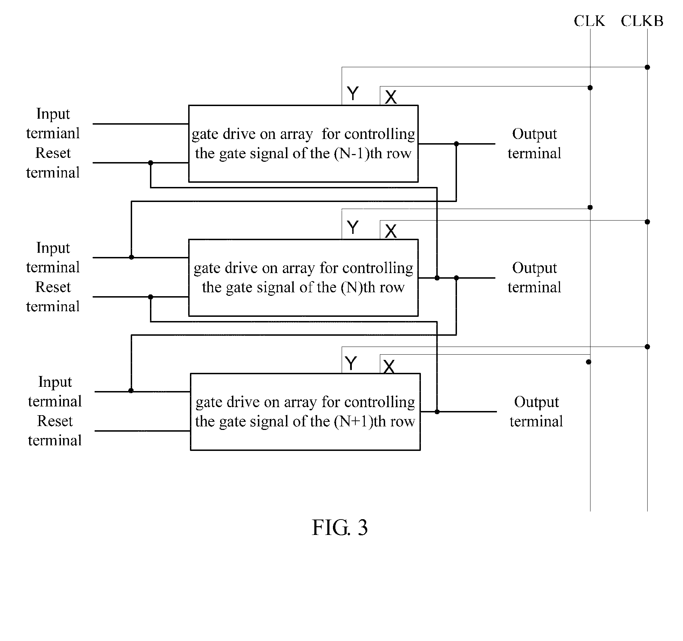

Based on the same conception, the embodiments of the present disclosure provide a shifting register comprising a plurality of the above-described gate drivers on array, each of the gate driver on array is used to control a gate signal of respective row, as shown in Fig.3, an input terminal of the gate driver on array for controlling the gate signal of the N^{th} row is connected with an output terminal of the gate driver on array for controlling the gate signal of the (N-1)^{th}row, an output terminal of the gate driver on array for controlling the gate signal of the N^{th} row is connected with an input terminal of the gate driver on array for controlling the gate signal of the (N+1)^{th}row and a reset terminal of the gate driver on array for controlling the gate signal of the N^{th} row is connected with the output terminal of the gate driver on array for controlling the gate signal of the (N+1)^{th} row, wherein N is equal to or more than 2. Regarding the gate driver on array for controlling the gate signal corresponding to an odd row, its first clock signal input terminal X is connected to a first clock signal line, such as CLK, and its second clock signal input terminal Y is connected to a second clock signal line, such as CLKB; regarding the gate driver on array for controlling the gate signal corresponding to an even row, its second clock signal input terminal Y is connected to a first clock signal line, and its first clock signal input terminal X is connected to a second clock signal line.

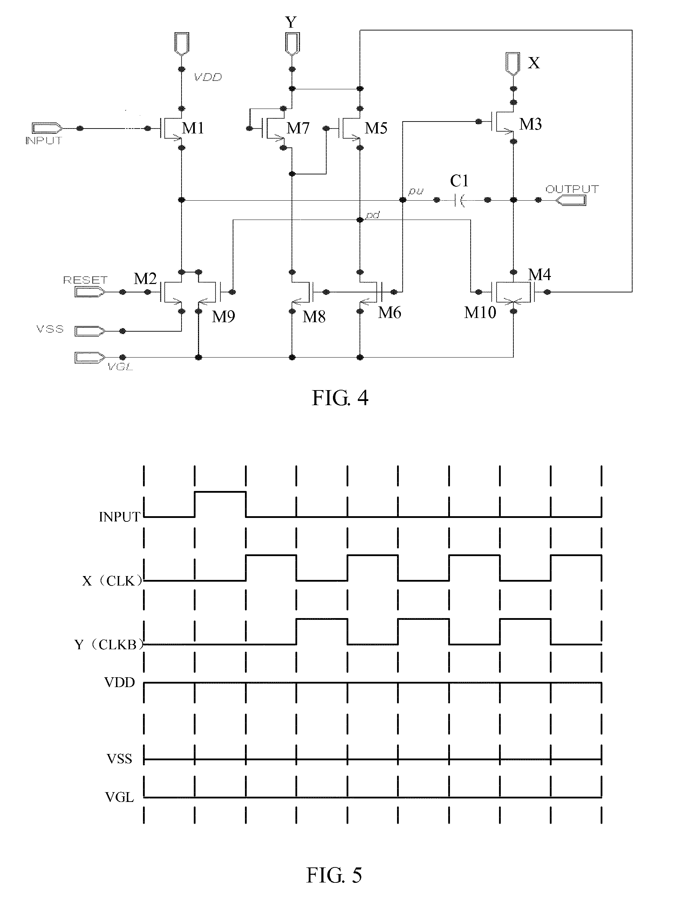

Below will describe the gate driver on array in the shifting register according to the present disclosure by means of specific embodiments. Making a 10T1C as an example, as shown in Fig.4, a first thin film field effect transistor TFT M1, a gate of which is connected with an input terminal INPUT of the gate driver on array, a drain of which is connected with a power supply voltage terminal VDD, and a source of which is connected with a first node PU being a pulling-up node; a second TFT M2, a gate of which is connected with a reset terminal RESET of the gate driver on array, a source of which is connected with a common connection voltage terminal VSS, and a drain of which is connected with the first node PU; a third TFT M3, a gate of which is connected with the first node PU, a source of which is connected with a first clock signal input terminal X, and a drain of which is connected with an output terminal OUTPUT; a fourth TFT M4, a gate of which is connected with a second clock signal input terminal Y, a drain of which is connected with the output terminal OUTPUT, and a source of which is connected with a low voltage signal terminal VGL; a capacitor C1 which is connected between the first node PU and the output terminal OUTPUT; a fifth TFT M5, a drain of which is connected with the second clock signal input terminal Y, and a source of which is connected with a second node PD being a pulling-down node; a sixth TFT M6, a drain of which is connected with the second node PD, a gate of which is connected with the first node PU, and a source of which is connected with the low voltage signal terminal VGL; a seventh TFT M7, a gate and a drain of which are connected with the second clock signal input terminal Y together, and a source of which is connected with the gate of the fifth TFT M5; a eighth TFT M8, a drain of which is connected with the source of the seventh TFT M7, a gate of which is connected with the first node PU, and a source of which is connected with the low voltage signal terminal VGL; a ninth TFT M9, a drain of which is connected with the first node PU, a gate of which is connected with the second node PD, and a source of which is connected with the low voltage signal terminal VGL; a tenth TFT M10, a drain of which is connected with the output terminal OUTPUT, a gate of which is connected with the second node PD, and a source of which is connected with the low voltage signal terminal VGL. Wherein the drain of the TFT M3 is the first clock signal input terminal X, and the drain of the TFT M5 is the second clock signal input terminal Y. When the current row is an odd row, the first clock signal input terminal X is connected to the first clock signal line CLK and the second clock signal input terminal Y is connected to the second clock signal line CLKB. When the current row is an even row, the first clock signal input terminal X is connected to the second clock signal line CLKB and the second clock signal input terminal Y is connected to the first clock signal line CLK.

Fig.5 is a timing sequence chart of voltages of respective terminals of the gate driver on array for controlling the gate signal corresponding to an odd row during the forward scan. It can be seen that, when the forward scan (from the first row to the last row) is performed, the VDD provides a constant high voltage and the VSS provides a constant low voltage, a high level pulse signal is input to the input terminal INPUT, so that the M1 is turned on and a voltage control bus PU node is in turn charged; next, the first clock signal input terminal X inputs a high level clock signal provided by the first clock signal line CLK, so that the M3 is turned on and the output terminal OUTPUT is controlled output a high level, while charges stored in the capacitor C1 transfers to the PU node and thus the voltage at the PU node further increases. Meanwhile, the M6 is turned on by the increased voltage at the PU node, and in turn pulls down the voltage at the second node PD to the voltage at the low voltage signal terminal VGL. Next, the reset terminal RESET is in the high level, so that the MS is turned on and the PU node is discharged; at the same time, the second clock signal input terminal Y inputs a high level clock signal provided by the second clock signal line CLKB, so that the M4 is turned on and the output terminal OUTPUT is discharged; further, the M5 is turned on and the PD node is charged, then the pulling-down M9 is controlled to discharge the PU node and the pulling-down TFT M10 is controlled to discharge the output terminal OUTPUT.

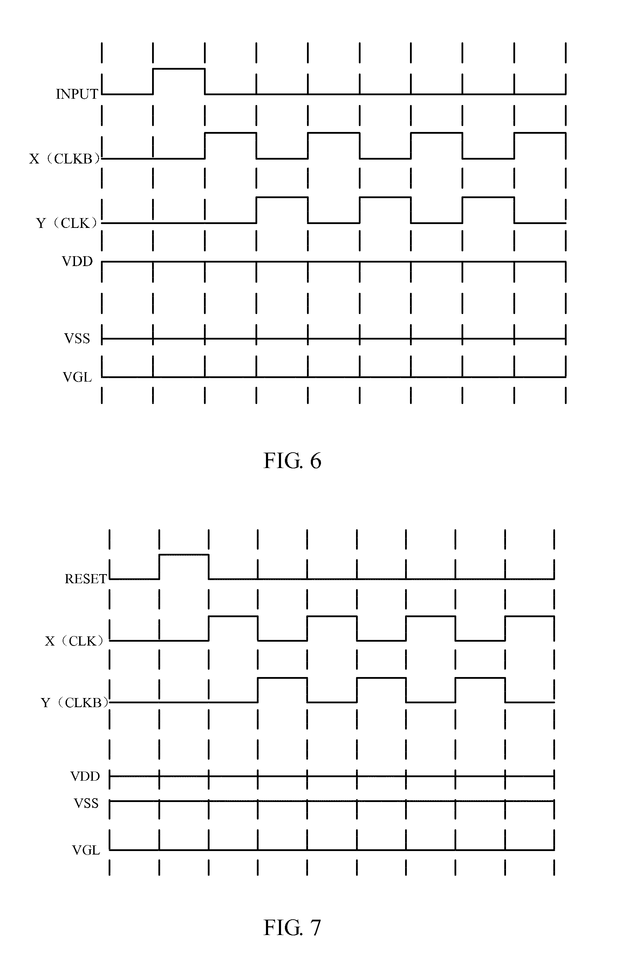

Fig. 6 is a timing sequence chart of voltages of respective terminals of the gate driver on array for controlling the gate signal corresponding to an even row during a forward scan. It can be seen that, when the forward scan (from the first row to the last row) is performed, the VDD provides a constant high voltage and the VSS provides a constant low voltage, a high level pulse signal is input to the input terminal INPUT, so that the M1 is turned on and the PU node is in turn charged; next, the first clock signal input terminal X inputs a high level clock signal provided by the second clock signal line CLKB, so that the M3 is turned on and the output terminal OUTPUT outputs the high level, while charges stored in the capacitor C1 transfers to the PU node and the voltage at the PU node further increases. Meanwhile, the M6 is turned on due to the increased voltage at the PU node, and in turn pulls down the voltage at the second node PD to the voltage at the low voltage signal terminal VGL. Next, the reset terminal RESET is in the high level, so that the M2 is turned on and the PU node is discharged; at the same time, the second clock signal input terminal Y inputs a high level clock signal provided by the first clock signal line CLK, so that the M4 is turned on and the output terminal OUTPUT is discharged; further, the M5 is turned on and the PD node is charged, then the pulling-down M9 is controlled to discharge the PU node and the pulling-down TFT M10 is controlled to discharge the output terminal OUTPUT.

Fig.7 is a timing sequence chart of voltages of respective terminals of the gate driver on array for controlling the gate signal corresponding to an odd row during a backward scan. It can be seen that, when the backward scan (from the last row to the first row) is performed, the VDD provides a constant low voltage and the VSS provides a constant high voltage, a high level pulse signal is input to the reset terminal RESET, so that the M2 is turned on and in turn the PU node is charged; next, the first clock signal input terminal X inputs a high level clock signal provided by the first clock signal line CLK, so that the M3 is turned on and the output terminal OUTPUT outputs the high level at this moment, while charges stored in the capacitor C1 transfers to the PU node and the voltage at the PU node further increases. Meanwhile, the M6 is turned on due to the increased voltage at the PU node, and in turn pulls down the voltage at the second node PD to the voltage at the low voltage signal terminal VGL. Next, the input terminal INPUT is in the high level, so that the M1 is turned on and the PU node is discharged; at the same time, the second clock signal input terminal Y inputs a high level clock signal provided by the second clock signal line CLKB, so that the M4 is turned on and the output terminal OUTPUT is discharged; further, the M5 is turned on and the PD node is charged, then the pulling-down M9 is controlled to discharge the PU node and the pulling-down TFT M10 is controlled to discharge the output terminal OUTPUT.

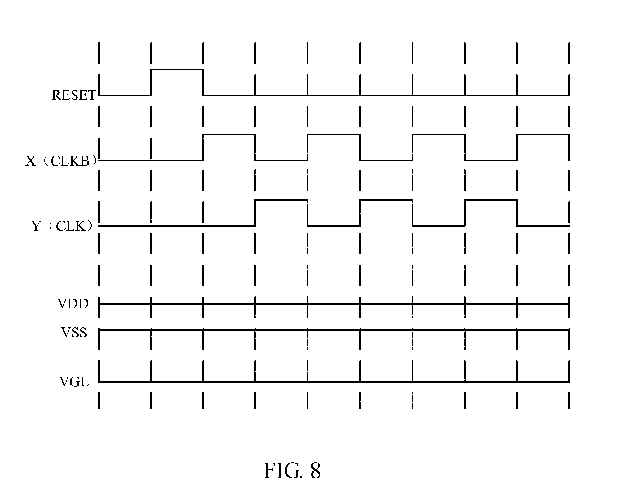

Fig.8 is a timing sequence chart of voltages of respective terminals of the gate driver on array for controlling the gate signal corresponding to an even row during a backward scan. It can be seen that, when the backward scan (from the last row to the first row) is performed, the VDD provides a constant low voltage and the VSS provides a constant high voltage, a high level pulse signal is input to the reset terminal RESET, so that the M2 is turned on and in turn the PU node is charged; next, the first clock signal input terminal X inputs a high level clock signal provided by the second clock signal line CLKB, so that the M3 is turned on and the output terminal OUTPUT outputs the high level, while charges stored in the capacitor C1 transfers to the PU node and the voltage at the PU node further increases. Meanwhile, the M6 is turned on due to the increased voltage at the PU node, and in turn pulls down the voltage at the second node PD to the voltage at the low voltage signal terminal VGL. Next, the input terminal INPUT is in the high level, so that the M1 is turned on and the PU node is discharged; at the same time, the second clock signal input terminal Y inputs a high level clock signal provided by the first clock signal line CLK, so that the M4 is turned on and the output terminal OUTPUT is discharged; further, the M5 is turned on and the PD node is charged, then the pulling-down M9 is controlled to discharge the PU node and the pulling-down TFT M10 is controlled to discharge the output terminal OUTPUT.

It can be seen from the above description that the gate driver on array according to the embodiments of the present disclosure enable the gate driver on array to achieve a bidirectional scan by designing the functions of the input terminal and the reset terminal in the gate driver on array as being implemented symmetrically, without changing a charging-discharging characteristic of nodes, which ensures a reliability and stabilization of the circuit.

Based on the same conception, the embodiments of the present disclosure provide a display screen comprising the above-described shifting register and an array substrate, a signal output terminal of each gate driver on array in the shifting register is connected with a gate line under the control of a gate signal output from the gate driver on array in the array substrate.

It can be seen from the above description that the gate driver on array, shifting register and display screen according to the embodiments of the present disclosure enable the gate driver on array to achieve a bidirectional scan by designing the functions of the input terminal and the reset terminal in the gate driver on array as being implemented symmetrically, without changing a charging-discharging characteristic of nodes, which ensures a reliability and stabilization of the circuit.

The above are only exemplary embodiments of the disclosed solution, but the scope sought for protection is not limited thereto. Instead, any or all modifications or replacements as would be obvious to those skilled in the art are intended to be included within the scope of the present invention. Therefore, the scope of the present invention is defined in the appended claims.

## Claims

1. A gate driver on array, comprising:
a first thin film field effect transistor TFT, a gate of which is connected with an input terminal of the gate driver on array, a drain of which is connected with a power supply voltage terminal VDD, and a source of which is connected with a first node being a pulling-up node;
a second TFT, a gate of which is connected with a reset terminal of the gate driver on array, a source of which is connected with a common connection voltage terminal VSS, and a drain of which is connected with the first node;
a third TFT, a gate of which is connected with the first node, a drain of which is connected with a first clock signal input terminal, and a source of which is connected with an output terminal;
a fourth TFT, a gate of which is connected with a second clock signal input terminal, a drain of which is connected with the output terminal, and a source of which is connected with a low voltage signal terminal;
a capacitor which is connected between the first node and the output terminal; and
a pulling-down module, which is connected among the first clock signal input terminal, the second clock signal input terminal, the first node and the output terminal, and is connected with the low voltage signal terminal, for maintaining the first node and the output terminal being in the low level during a non-operation period of the gate driver on array.

2. A gate driver on array as claimed in claim 1, wherein the pulling-down module comprises:
a fifth TFT, a drain of which is connected with the second clock signal input terminal, and a source of which is connected with a second node being a pulling-down node;
a sixth TFT, a drain of which is connected with the second node, a gate of which is connected with the first node, and a source of which is connected with the low voltage signal terminal;
a seventh TFT, a gate and a drain of which are connected with the second clock signal input terminal together, and a source of which is connected with a gate of the fifth TFT;
a eighth TFT, a drain of which is connected with the source of the seventh TFT, a gate of which is connected with the first node, and a source of which is connected with the low voltage signal terminal;
a ninth TFT, a drain of which is connected with the first node, a gate of which is connected with the second node, and a source of which is connected with the low voltage signal terminal; and
a tenth TFT, a drain of which is connected with the output terminal, a gate of which is connected with the second node, and a source of which is connected with the low voltage signal terminal.

3. A gate driver on array as claimed in claim 1, wherein the first clock signal input terminal of the gate driver on array is connected to the first clock signal line, and the second clock signal input terminal of the gate driver on array is connected to the second clock signal line, when the gate driver on array is used to control the gate signal corresponding to an odd row;
the second clock signal input terminal of the gate driver on array is connected to the first clock signal line, and the first clock signal input terminal of the gate driver on array is connected to the second clock signal line, when the gate driver on array is used to control the gate signal corresponding to an even row.

4. A shifting register, comprising:
a plurality of gate drivers on array, each of the gate drivers on array is used to control a gate signal of respective row, wherein an input terminal of the gate driver on array for controlling the gate signal of the N^{th} row is connected with an output terminal of the gate driver on array for controlling the gate signal of the (N-1)^{th} row, an output terminal of the gate driver on array for controlling the gate signal of the N^{th} row is connected with an input terminal of the gate driver on array for controlling the gate signal of the (N+1)^{th} row and a reset terminal of the gate driver on array for controlling the gate signal of the N^{th} row is connected with the output terminal of the gate driver on array for controlling the gate signal of the (N+1)^{th}row, wherein N is equal to or more than 2,
each of the gate drivers on array comprises:
a first thin film field effect transistor TFT, a gate of which is connected with an input terminal of the gate driver on array, a drain of which is connected with a power supply voltage terminal VDD, and a source of which is connected with a first node being a pulling-up node;
a second TFT, a gate of which is connected with a reset terminal of the gate driver on array, a source of which is connected with a common connection voltage terminal VSS, and a drain of which is connected with the first node;
a third TFT, a gate of which is connected with the first node, a drain of which is connected with a first clock signal input terminal, and a source of which is connected with an output terminal;
a fourth TFT, a gate of which is connected with a second clock signal input terminal, a drain of which is connected with the output terminal, and a source of which is connected with a low voltage signal terminal;
a capacitor which is connected between the first node and the output terminal; and
a pulling-down module, which is connected among the first clock signal input terminal, the second clock signal input terminal, the first node and the output terminal, and is connected with the low voltage signal terminal, for maintaining the first node and the output terminal being in the low level during a non-operation period of the gate driver on array.

5. A shifting register as claimed in claim 4, wherein the pulling-down module comprises:
a fifth TFT, a drain of which is connected with the second clock signal input terminal, and a source of which is connected with a second node being a pulling-down node;
a sixth TFT, a drain of which is connected with the second node, a gate of which is connected with the first node, and a source of which is connected with the low voltage signal terminal;
a seventh TFT, a gate and a drain of which are connected with the second clock signal input terminal together, and a source of which is connected with a gate of the fifth TFT;
a eighth TFT, a drain of which is connected with the source of the seventh TFT, a gate of which is connected with the first node, and a source of which is connected with the low voltage signal terminal;
a ninth TFT, a drain of which is connected with the first node, a gate of which is connected with the second node, and a source of which is connected with the low voltage signal terminal; and
a tenth TFT, a drain of which is connected with the output terminal, a gate of which is connected with the second node, and a source of which is connected with the low voltage signal terminal.

6. A shifting register as claimed in claim 5, wherein the first clock signal input terminal of the gate driver on array is connected to the first clock signal line, and the second clock signal input terminal of the gate driver on array is connected to the second clock signal line, when the gate driver on array is used to control the gate signal corresponding to an odd row;
the second clock signal input terminal of the gate driver on array is connected to the first clock signal line, and the first clock signal input terminal of the gate driver on array is connected to the second clock signal line, when the gate driver on array is used to control the gate signal corresponding to an even row.

7. A shifting register as claimed in claim 6, wherein, regarding the gate driver on array for controlling the gate signal corresponding to an odd row,
the VDD provides a constant high level and the VSS provides a constant low level when a forward scan is initiated,
a high level pulse signal is input to the input terminal of the gate driver on array, and the first node is charged via the drain of the first TFT;
the first clock signal input terminal receives a high level clock signal provided by the first clock signal line, the output terminal is controlled by the third TFT so as to output a high level; the sixth TFT is turned on and pulls down the voltage at the second node to the voltage at the low voltage signal terminal;
the reset terminal connected to the gate of the second TFT is in a high level, and the first node is discharged;
the second clock signal input terminal receives a high level clock signal provided by the second clock signal line, and the output terminal is discharged via the fourth TFT; the second node is charged through the fifth TFT, the ninth TFT is controlled to discharge the first node and the tenth TFT is controlled to discharge the output terminal.

8. A shifting register as claimed in claim 6, wherein, regarding the gate driver on array for controlling the gate signal corresponding to an even row,
the VDD provides a constant high level and the VSS provides a constant low level when a forward scan is initiated,
a high level pulse signal is input to the input terminal of the gate driver on array, and the first node is charged via the drain of the first TFT;
the first clock signal input terminal receives a high level clock signal provided by the second clock signal line, the output terminal is controlled by the third TFT so as to output a high level; the sixth TFT is turned on and pulls down the voltage at the second node to the voltage at the low voltage signal terminal;
the reset terminal connected to the gate of the second TFT is in a high level, and the first node is discharged;
the second clock signal input terminal receives a high level clock signal provided by the first clock signal line, and the output terminal is discharged via the fourth TFT; the second node is charged through the fifth TFT, the ninth TFT is controlled to discharge the first node and the tenth TFT is controlled to discharge the output terminal.

9. A shifting register as claimed in claim 6, wherein, regarding the gate driver on array for controlling the gate signal corresponding to an odd row,
the VDD provides a constant low level and the VSS provides a constant high level when a backward scan is initiated,
a high level pulse signal is input to the reset terminal of the gate driver on array, and the first node is discharged through the source of the second TFT;
the first clock signal input terminal receives a high level clock signal provided by the first clock signal line, the output terminal is controlled by the third TFT so as to output a high level; the sixth TFT is turned on and pulls down the voltage at the second node to the voltage at the low voltage signal terminal;
the input terminal connected to the gate of the first TFT is in a high level, and the first node is discharged;
the second clock signal input terminal receives a high level clock signal provided by the second clock signal line, and the output terminal is discharged via the fourth TFT; the second node is charged through the fifth TFT, the ninth TFT is controlled to discharge the first node and the tenth TFT is controlled to discharge the output terminal.

10. A shifting register as claimed in claim 6, wherein, regarding the gate driver on array for controlling the gate signal corresponding to an even row,
the VDD provides a constant low level and the VSS provides a constant high level when a backward scan is initiated,
a high level pulse signal is input to the reset terminal of the gate driver on array, and the first node is discharged through the source of the second TFT;
the first clock signal input terminal receives a high level clock signal provided by the second clock signal line, the output terminal is controlled by the third TFT so as to output a high level; the sixth TFT is turned on and pulls down the voltage at the second node to the voltage at the low voltage signal terminal;
the input terminal connected to the gate of the first TFT is in a high level, and the first node is discharged;
the second clock signal input terminal receives a high level clock signal provided by the first clock signal line, and the output terminal is discharged via the fourth TFT; the second node is charged through the fifth TFT, the ninth TFT is controlled to discharge the first node and the tenth TFT is controlled to discharge the output terminal.

11. A display screen, comprising: a shifting register as claimed in any one of claims 4-10, and an array substrate;
a signal output terminal of the shifting register is connected with a gate line of the array substrate.
